# EUROPÄISCHE PATENTSCHRIFT

(11) **EP 1 816 480 B1**
(45) Veröffentlichungstag und Bekanntmachung des Hinweises auf die Patenterteilung: **07.12.2016**
(21) Anmeldenummer: 07002350.2
(22) Anmeldetag: 02.02.2007
(51) Int. Cl.: G01R 1/067, G01R 13/34

(54) **Oszilloskop mit Frequenzversatz im Eingangsbereich**
Oscilloscope with input frequency shift
Oscilloscope à décalage de fréquence d'entrée

(30) Priorität: 02.02.2006 DE 102006004841
(43) Veröffentlichungstag der Anmeldung: 08.08.2007
(73) Patentinhaber: Rohde & Schwarz GmbH & Co. KG, 81671 München (DE)
(72) Erfinder: Vohrer, Michael, 85570 Ottenhofen (DE)
(74) Vertreter: Körfer, Thomas

(56) Entgegenhaltungen:
- WO-A-02/10776
- WO-A-2004/038432
- WO-A1-2006/092109
- DE-A1- 4 203 819
- JP-A- 9 089 933
- US-A- 5 146 171
- US-A- 5 231 349
- US-A- 5 847 569
- US-A1- 2002 016 691
- US-B1- 6 242 899

## Beschreibung

Die Erfindung betrifft ein digitales Oszilloskop.

Digitale Oszilloskope, d. h. Oszilloskope mit digitalem Speicher, sind aus einer Vielzahl von Druckschriften, beispielsweise aus der GB 2 399 647 A bekannt. Die höchste Eingangsfrequenz von digitalen Oszilloskopen ist grundsätzlich durch den Analog/Digital-Wandler begrenzt. Der Analog/Digital-Wandler tastet das analoge Eingangssignal mit einer festen Abtastrate ab. Nach dem Nyquist-Theorem muss die Abtastrate mindestens doppelt so groß sein, wie die höchste Frequenz in dem Spektrum des abzutastenden Analog-Signals. In der Regel wird aber eine wesentlich höhere Abtastfrequenz als die theoretische Grenze verwendet. Die maximal verwendbare Abtastrate wiederum hängt von der Technologie des Analog/DigitalWandlers ab. Auch bei modernen parallel arbeitenden Flash-Wandlern ist die Abtastrate auf den unteren GHz-Bereich begrenzt.

Aus der WO 2004/038432 A2 ist ein Oszilloskop bekannt, welches ein sehr breitbandiges Messsignal verarbeiten und darstellen kann. Das Messsignal wird auf mehrere Signalteile aufgeteilt, welche in Summe das gesamte Messsignal ergeben. Dabei werden die einzelnen Signalanteile von einem Mischer mittels eines Lokaloszillatorsignals in einen niedrigeren Frequenzbereich transformiert und digitalisiert. Die digitalisierten Einzelsignale werden wiederum entsprechend digital hochgemischt und zu einem Gesamtsignal zusammengesetzt.

Aus der WO 02/10776 A1 ist ein Leistungsmessgerät bekannt, in dem ein Lokaloszillatorsignal über eine Leitung an einen Tastkopf übertragen wird, um dort mit einem Hochfrequenzsignal zu einem Zwischenfrequenzsignal gemischt zu werden. Das Zwischenfrequenzsignal wird anschließend über die Leitung wieder zurück zum Leistungsmessgerät übertragen, digitalisiert und ausgewertet.

In der Praxis besteht aber das Bedürfnis, auch höherfrequente Eingangssignale mit digitalen Oszilloskopen darzustellen. Dies war bisher jedoch nicht möglich.

Der Erfindung liegt die Aufgabe zugrunde, ein Oszilloskop anzugeben, welches es auch ermöglicht, bandbegrenzte Signale zu analysieren, deren Mittenfrequenz wesentlich höher als die Frequenzbegrenzung des Analog/DigitalWandlers ist.

Die Aufgabe wird durch die Merkmale des Anspruchs 1 gelöst. Die Unteransprüche enthalten vorteilhafte Weiterbildungen der Erfindung.

Erfindungsgemäß wird vorgeschlagen, in einem Eingangsbereich des Oszilloskops einen Frequenz-Shifter vorzusehen, welcher das Eingangs-Messsignal in einen niedrigeren Frequenzbereich versetzt (shiftet), welcher durch den Analog/Digital-Wandler noch verarbeitet werden kann.

Der Eingangsbereich enthält dazu vorzugsweise einen Mischer, welcher das Eingangs-Messsignal mit dem Signal eines lokalen Oszillators für den Zweck der Frequenzverringerung mischt. Die Frequenz des lokalen Oszillators ist vorzugsweise veränderbar und an die Mittenfrequenz des Eingangs-Messsignals anpassbar.

Der Eingangsbereich mit dem Frequenz-Shifter kann in dem Hauptgerät des Oszilloskops angeordnet sein. Besonders bevorzugt ist der Frequenz-Shifter aber bereits im Tastkopf angeordnet, so dass auf dem Verbindungskabel zwischen dem Tastkopf und der Eingangsbuchse des Hauptgeräts bereits das in den unteren Frequenzbereich versetzte Signal übertragen wird. Alternativ ist es auch möglich, nur den Mischer in dem Tastkopf anzuordnen und den lokalen Oszillator im Hauptgerät vorzusehen und über das Verbindungskabel das Signal des lokalen Oszillators zu übertragen. Wenn das lokale Oszillatorsignal durch einen Synthesizer erzeugt wird, welcher ein relativ großes Bauvolumen erfordert, kann diese Aufteilung sinnvoll sein. Auch ist es dann einfacher, die Frequenz des lokalen Oszillators entsprechend der Vorgabe durch die Bedienperson einzustellen.

Ausführungsbeispiele der Erfindung werden nachfolgend unter Bezugnahme auf die Zeichnung näher erläutert. In der Zeichnung zeigen:
- Fig. 1: ein Blockschaltbild eines ersten nicht erfindungsgemäßen Ausführungsbeispiels des Oszilloskops;
- Fig. 2: das Spektrum des bandbegrenzten Eingangssignals;
- Fig. 3: das Spektrum des im Eingangsbereich frequenzversetzten Messsignals;
- Fig. 4: ein Blockschaltbild eines zweiten Ausführungsbeispiels des erfindungsgemäßen Oszilloskops und
- Fig. 5: ein Blockschaltbild eines dritten nicht erfindungsgemäßen Ausführungs beispiels des Oszilloskops.

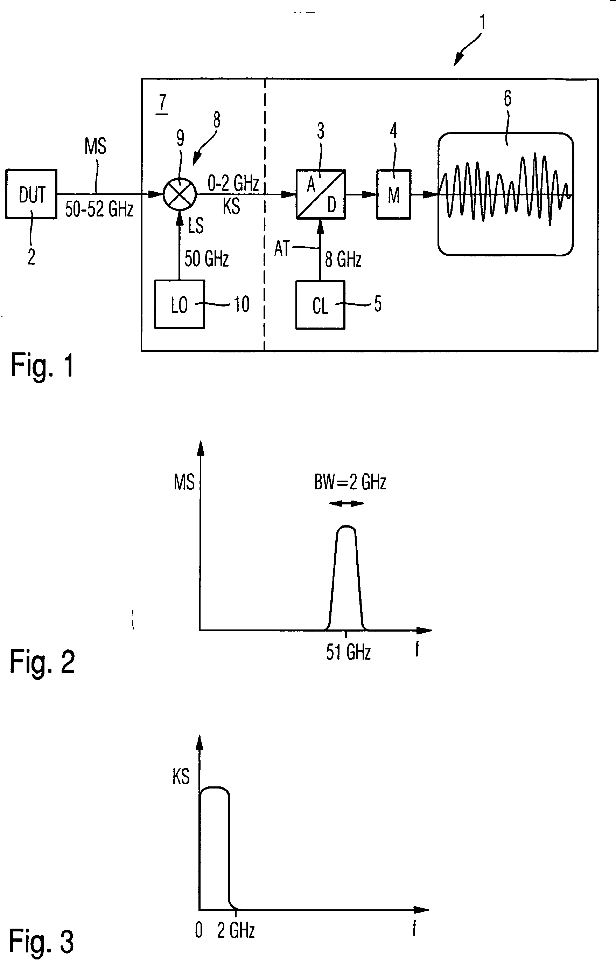

Fig. 1 zeigt ein erstes Ausführungsbeispiel des erfindungsgemäßen Oszilloskops 1. Das Oszilloskop 1 dient zur Vermessung des Ausgangssignals eines Messobjekts (DUT = Device under Test) 2. Wie bei digitalen Oszilloskopen üblich, weist auch das erfindungsgemäße Oszilloskop 1 einen Analog/Digital-Wandler 3 auf, um das Analog-Signal zu konvertieren und die Digitalwerte in einem Speicher 4 abzulegen. Der Analog/Digital-Wandler 3 erzeugt dabei bei jeder Periode eines Abtasttakts AT jeweils einen Abtastwert. Der Abtasttakt AT wird durch einen Taktgenerator 5 erzeugt, der mit dem Analog/DigitalWandler 3 in Verbindung steht. Die in dem Speicher 4 abgespeicherten Digitalwerte können dann in ihrer zeitlichen Reihenfolge auf einer Anzeigeeinrichtung (Display) 6 angezeigt werden.

Entsprechend dem Nyquist-Theorem muss die Frequenz des Abtasttakts AT mindestens doppelt so groß sein wie die höchste Frequenz in dem Spektrum des Analog-Signals. Typischerweise werden aber höhere Abtastraten zur Vergrößerung der Signalauflösung verwendet. Im in Fig. 1 dargestellten Beispiel beträgt die Abtastrate 8 GHz und die Bandbreite des Analog/Digital-Wandlers ist auf 2 GHz begrenzt, das heißt im Analog/Digital-Wandler 3 kann ein Analog-Signal im Bereich zwischen 0 und 2 GHz anliegen.

In der Praxis besteht aber das Bedürfnis auch höherfrequente Signale zu analysieren. An dieser Stelle setzt die Erfindung ein und schlägt vor, durch einen geeignet ausgestalteten Eingangsbereich 7 das Eingangs-Messsignal in seiner Frequenz zu versetzen und somit der Analyse zuzuführen. Das Eingangs-Messsignal MS muss allerdings entsprechend bandbegrenzt sein, d.h. die Bandbreite des Eingangs-Messsignals MS darf nicht größer sein als die Frequenzbegrenzung des Analog/DigitalWandlers. Im oben angegebenen Beispiel darf die Bandbreite daher 2 GHz nicht überschreiten.

Der Eingangsbereich 7 des Oszilloskops 1 weist eine entsprechende Frequenzumsetzeinrichtung 8 auf, die im Ausführungsbeispiel aus einem Mischer 9 und einem lokalen Oszillator 10 besteht. Das von dem lokalen Oszillator 10 erzeugte lokale Oszillatorsignal, welches dem Mischer 9 zugeführt wird, sollte der kleinsten Frequenz im Spektrum des Messsignals MS entsprechen. Wenn das Messsignal MS beispielsweise ein Spektrum hat, welches sich zwischen 50 GHz bis 52 GHz erstreckt, so sollte die Frequenz des lokalen Oszillators 10 beispielsweise 50 GHz betragen, so dass am Ausgang des Mischers 9 das um 50 GHz verschobene Spektrum entsteht, welches sich zwischen 0 bis 2 GHz erstreckt und somit von dem Analog/Digital-Wandler 3 verarbeitet werden kann.

Durch den Frequenzversetzer 8 am Eingang des Oszilloskops 1 wird somit die Analyse bandbegrenzter Messsignale MS ermöglicht. Solche bandbegrenzten Messsignale treten in der Funk-Messtechnik, insbesondere der Mobilfunk-Messtechnik, häufig als modulierte Trägersignale auf.

In Fig. 2 ist das Spektrum des Eingangs-Messsignals MS dargestellt, welches eine Bandbreite von 2 GHz hat und sich um die Mittenfrequenz von 51 GHz erstreckt.

Fig. 3 zeigt das um 50 GHz herabgesetzte Spektrum, welches sich nun zwischen 0 und 2 GHz erstreckt.

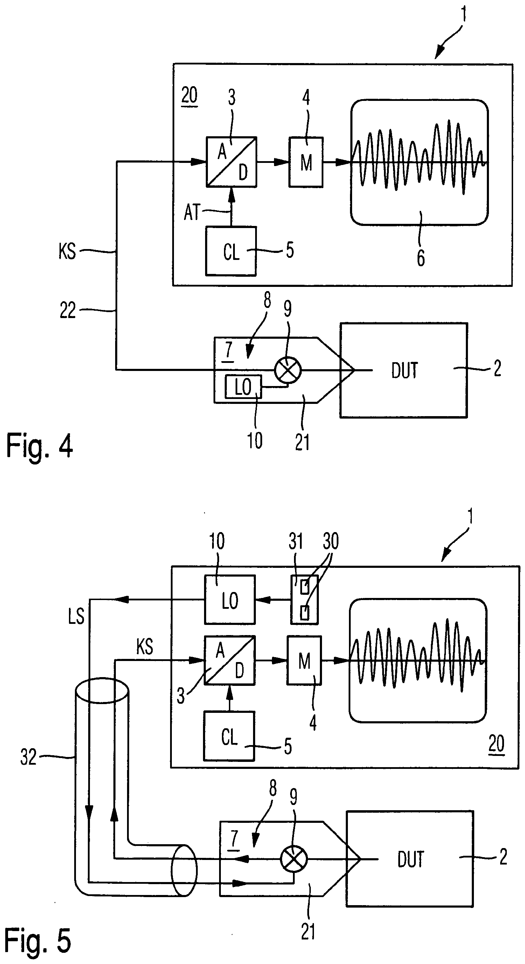

Fig. 4 zeigt ein erstes alternatives Ausführungsbeispiel. Bereits beschriebene Elemente sind mit übereinstimmenden Bezugszeichen versehen, so dass sich eine wiederholende Beschreibung erübrigt. Im Gegensatz zu dem anhand von Fig. 1 beschriebenen Ausführungsbeispiel befindet sich bei dem in Fig. 4 dargestellten Ausführungsbeispiel der Eingangsbereich 7 mit dem Frequenzkonverter 8 nicht innerhalb des Hauptgeräts 20, sondern innerhalb eines davon abgesetzten Tastkopfs 21, welche über eine Verbindungsleitung 22 mit dem Hauptgerät 20 verbunden ist. Der Vorteil besteht darin, dass das sehr hochfrequente Messsignal MS nicht unmittelbar über die Verbindungsleitung 22 übertragen werden muss. Statt dessen wird das in der Frequenz herabgesetzte konvertierte Analog-Signal KS über die Verbindungsleitung 22 übertragen. Bei dem in Fig. 4 dargestellten Ausführungsbeispiel befinden sich sowohl der Mischer 9 als auch der lokale Oszillator 10 innerhalb des Tastkopfs 21.

Fig. 5 zeigt ein drittes nicht erfindungsgemäßen Ausführungsbeispiels des Oszilloskops 1. Im Gegensatz zu dem in Fig. 4 erläuterten Ausführungsbeispiel ist bei dem in Fig. 5 gezeigten Ausführungsbeispiel nur der Mischer 9 innerhalb des Tastkopfs 21 angeordnet. Der lokale Oszillator 10 hingegen befindet sich innerhalb des Hauptgeräts 20. Dies hat insoweit Vorteile, als der lokale Oszillator 10 bei dieser Ausgestaltung in einfacher Weise beispielsweise durch innerhalb eines Bedienfelds 31 an der Frontseite des Oszilloskops 1 angeordnete Bedienelemente 30 in seiner Frequenz verändert werden kann. Der lokale Oszillator 10 kann dabei auch eine größere räumliche Bauform einnehmen, was in der Regel erforderlich ist, wenn der lokale Oszillator als hochgenauer Synthesizer mit mehreren PLL-Stufen aufgebaut wird. Der Mischer 9 hingegen kann im einfachsten Fall als Dioden-Ringmischer ausgebildet sein, der problemlos innerhalb des Tastkopfs 21 integrierbar ist. Das Oszillatorsignal LS des lokalen Oszillators 10 und das von dem Mischer 9 erzeugte konvertierte Analogsignal KS können innerhalb eines gemeinsamen Verbindungskabels 32 geführt werden.

Die Erfindung ist nicht auf die dargestellten Ausführungsbeispiele beschränkt. Insbesondere kann der Frequenzkonverter 8 auch anders ausgebildet sein und die Frequenzkonvertierung kann beispielsweise über mehrere Stufen erfolgen. Alle vorstehend beschriebenen oder in den Figuren gezeigten Merkmale können im Rahmen der Erfindung beliebig miteinander kombiniert werden.

## Patentansprüche

1. Oszilloskop (1) zum Messen eines Eingangs-Messsignals (MS) mit einem Analog/Digital-Wandler (3), der ein analoges Signal mit einer vorgegebenen Abtastrate abtastet, wobei ein Frequenzkonverter (8) das Eingangs-Messsignal (MS) in ein konvertiertes Analog-Signal (KS) durch Verringerung der Frequenz konvertiert,
**dadurch gekennzeichnet,**
**dass** der Frequenzkonverter (8) einen Mischer (9) und einen lokalen Oszillator (10) aufweist und sowohl der Mischer (9) als auch der lokale Oszillator (10) innerhalb eines Tastkopfes (21) des Oszilloskops (1) angeordnet ist.

2. Oszilloskop nach Anspruch 1,
**dadurch gekennzeichnet,**
**dass** die Frequenz des lokalen Oszillators (10) veränderbar ist.

3. Oszilloskop nach Anspruch 1 oder 2,
**dadurch gekennzeichnet,**
**dass** das Eingängs-Messsignal (MS) bandbegrenzt ist und die in dem Frequenzkonverter (8) vorgenommene Frequenzverschiebung im Wesentlichen der niedrigsten Frequenz des bandbegrenzten Eingangs-Messsignals (MS) entspricht.

## Claims

1. Oscilloscope (1) for measuring an input measurement signal (MS) with an analogue/digital converter (3), which samples an analogue signal with a predetermined sampling rate, wherein a frequency converter (8) converts the input measurement signal (MS) into a converted analogue signal (KS) by reducing the frequency,
**characterised in that**
the frequency converter (8) comprises a mixer (9) and a local oscillator (10) and both the mixer (9) and the local oscillator (10) are arranged inside a sampling head (21) of the oscilloscope (1).

2. Oscilloscope according to claim 1,
**characterised in that**
the frequency of the local oscillator (10) is variable.

3. Oscilloscope according to claim 1 or 2,
**characterised in that**
the input measurement signal (MS) is band-limited and the frequency shift carried out in the frequency converter (8) essentially corresponds to the lowest frequency of the band-limited input measurement signal (MS).

## Revendications

1. Oscilloscope (1) permettant de mesurer un signal de mesure d'entrée (MS) comprenant un convertisseur analogique/numérique (3), qui détecte un signal analogique à une vitesse de détection prédéfinie, dans lequel un convertisseur de fréquence (8) convertit le signal de mesure d'entrée (MS) en signal analogique (KS) converti par réduction de la fréquence,
**caractérisé**
**en ce que** le convertisseur de fréquence (8) comprend un mélangeur (9) et un oscillateur local (10) et aussi bien le mélangeur (9) que l'oscillateur local (10) sont disposés à l'intérieur d'une sonde (21) de l'oscilloscope (1).

2. Oscilloscope selon la revendication 1,
**caractérisé**
**en ce que** la fréquence de l'oscillateur local (10) est variable.

3. Oscilloscope selon la revendication 1 ou 2,
**caractérisé**
**en ce que** le signal de mesure d'entrée (MS) est limité en bande et le décalage de fréquence réalisé dans le convertisseur de fréquence (8) correspond sensiblement à la fréquence la plus basse du signal de mesure d'entrée (MS) limité en bande.
